# EUROPEAN PATENT APPLICATION

(11) **EP 4 020 588 A1**
(43) Date of publication of application: **29.06.2022**
(21) Application number: 20217391.0
(22) Date of filing: 28.12.2020
(51) Int. Cl.: H01L 29/66, H01L 29/786, H01L 29/45

(54) **METHOD FOR PROCESSING A FET DEVICE**

(71) Applicant: IMEC VZW, 3001 Leuven (BE)
(72) Inventor: Rassoul, Nouredine, 3001 Leuven (BE); Donadio, Gabriele Luca, 3001 Leuven (BE); Kar, Gouri Sankar, 3001 Leuven (BE)
(74) Representative: Roth, Sebastian

(57) **Abstract**

The disclosure relates to a method for processing a FET device, in particular a metal-oxide-semiconductor field-effect transistor, MOSFET, or a thin-film-transistor, TFT. The method comprises:
- providing a substrate (11);
- forming a first oxide semiconductor layer (17) and a second oxide semiconductor layer (18) above the substrate (11);
- forming a source structure (25-1) and a drain structure (25-2) on the second oxide semiconductor layer (18);
- forming a gate structure (43) on the first oxide semiconductor layer (17);
- wherein the first oxide semiconductor layer (17) forms a channel between the source structure (25-1) and the drain structure (25-2); and
- wherein the second oxide semiconductor layer (18) forms a contact layer to the source structure (25-1) and the drain structure (25-2).

## Description

### TECHNICAL FIELD

The present disclosure relates to a method for processing a FET device, in particular a metal-oxide-semiconductor field-effect transistor, MOSFET, or a thin-film-transistor, TFT. The present disclosure further relates to a structure for a FET device.

### BACKGROUND

Field effect transistors (FETs) are key electronic components in various electronic devices. Generally, a FET comprises a channel that is arranged between a source and a drain contact, as well as a gate contact that is arranged in close proximity to the channel. An electric field is applied to the gate contact to control a current flow through the channel. Thin-film-transistors (TFTs) are special types of FETs that are made by depositing thin films, usually semiconductor layers, dielectric layers and metallic contacts, on non-conducting substrates.

Many modern applications, such as high-density memories, display-on-glass devices, or smart nano-interconnects, comprise such FETs. These devices often operate on a limited power budget and, thus, require a better managing of electric power at the circuit and the FET level.

Oxide semiconductor materials may be used for the channel layer of a FET. Indium gallium zinc oxide (InGaZnO, or short: IGZO) is an oxide semiconductor material that provides several advantages, especially compared to doped amorphous silicon, when used as a channel layer. These advantages are, amongst others, an ultra-low off-state leakage current and a high electron mobility. Further, IGZO allows processing with a low thermal budget, i.e. at low temperatures, enabling a sequential integration with conventional silicon-based transistors.

There are two main doping mechanisms for amorphous IGZO (a-IGZO): Off stoichiometry of oxygen ions and diffusion of hydrogen. For the first defect family, oxygen vacancies act as n-type dopants and form shallow donor levels in the IGZO bandgap. Regarding the role of hydrogen, the lead model is linked to the break of weakly-bonded oxygen atoms like in Zn-O by H and forming -OH ions.

However, it is difficult to control the electrical properties of a channel layer of a FET and to avoid damage to the layer during the FET fabrication. In particular, it is difficult to control the concentration of oxygen vacancies in an IGZO channel, especially because hydrogen-based chemistries are commonly used in deposition and patterning steps of a FET fabrication process subsequent to the formation the IGZO channel.

Moreover, because the channel of a FET, in particular of a TFT, is generally covered by other structures, such as a metal gate or a top gate insulator, it is difficult to repair a damaged channel layer, e.g. to recover generated defects in the layer, following the deposition of these other layers.

Furthermore, there are different requirements for the electrical resistivity of the channel layer and of the contact areas between the channel and the source/drain areas of the FET. Typically, the channel should have a high resistivity, while the contact areas should have a high conductivity. Attempts to repair a damaged channel layer can cause a degradation of the contact and access resistances of the contact areas. At the same time, attempts to modify the contact areas can negatively affect the channel layer. This is due to the critical dimension of the channel and its proximity to the contact areas.

### SUMMARY

Thus, it is an objective to provide an improved method for processing a FET device, and to provide an improved structure for a FET device. In particular, the above-mentioned disadvantages should be avoided.

The objective is achieved by the embodiments provided in the enclosed independent claims. Advantageous implementations of the embodiments of the invention are further defined in the dependent claims.

According to a first aspect, the present disclosure relates to a method for processing a FET device, in particular a metal-oxide-semiconductor field-effect transistor (MOSFET) or a thin-film-transistor (TFT), wherein the method comprises:
- providing a substrate;
- forming a first oxide semiconductor layer and a second oxide semiconductor layer above the substrate;
- forming a source structure and a drain structure on the second oxide semiconductor layer;
- forming a gate structure on the first oxide semiconductor layer;
- wherein the first oxide semiconductor layer forms a channel between the source structure and the drain structure; and
- wherein the second oxide semiconductor layer forms a contact layer to the source structure and the drain structure.

This achieves the advantage that the contact layer can be controlled independently from the channel layer, e.g in terms of thickness or resistivity. Thus, the contact resistivity between the channel and the source/drain structures can be optimized without negatively affecting the channel itself, and vice versa.

The FET device can be a planar transistor, in particular a TFT, or another type of transistor, such as a fin field-effect transistor (FinFET).

The substrate can be a glass or a silicon substrate. Preferably, the substrate is a wafer.

Each of the first and the second oxide semiconductor layers can be a metal-oxide semiconductor or a doped metal-semiconductor layer.

The source structure, the drain structure and/or the gate structure are, preferably, at least partially metallic structures, i.e. these structures are at least partially formed from a metallic material.

In an embodiment, the first and/or the second oxide semiconductor layer comprises any one of the following materials: indium gallium zinc oxide (IGZO), indium tin oxide (ITO) or indium zinc oxide (IZO).

In an embodiment, the method further comprises the step of:
- performing an oxygen annealing to modify a doping of the first oxide semiconductor layer.

This achieves the electrical properties of the FET, especially its channel layer can be efficiently controlled. In particular, damages or defects in the channel layer that are, for instance, introduced during fabrication of the device and that change the doping of said layer in an unwanted way can be removed, and a desired concentration of oxygen dopants in the layer can be recovered. In particular, modifying the doping may refer to changing or restoring the doping, in particular a concentration of dopants, to a desired value.

Due to the channel layer and the contact layer existing as two separate oxide semiconductor layers, the oxygen annealing, preferably, only affects the channel layer and has no negative impact on the contact layer.

Modifying the doping of the first oxide semiconductor layer may refer to a restoring of damages and/or a filling up of oxygen (02) vacancies that occurred during the fabrication of the FET.

In particular, this annealing step can be carried out after depositing other layers or structures, such as the gate structure or a top gate isolator.

In an embodiment, the source and the drain structure are formed by:
- forming a metallic layer on the second oxide semiconductor layer, and
- patterning the metallic layer thereby forming the source structure and the drain structure.

This achieves the advantage that the source and the drain structures can be efficiently formed from a single metallic layer. The material of the metallic layer can be selected based to optimize the contact resistivity to the contact layer.

The step of patterning the metallic layer may comprise forming a trench in the metallic layer by recessing the metallic layer in a center region, wherein the trench separates the metallic layer into the source and the drain structures.

In an embodiment, the step of patterning the metallic layer comprises separating said second oxide semiconductor layer into a first contact layer to the source structure and a second contact layer to the drain structure.

This achieves the advantage that source and drain contact layers can be efficiently formed from the second oxide semiconductor layer.

For example, the trench formed during the patterning passes through the second oxide semiconductor layer, and separates said second oxide semiconductor layer into the first and second contact layers.

In an embodiment, the first oxide semiconductor layer is formed on the substrate, wherein the second oxide semiconductor layer is formed on the first oxide semiconductor layer, and wherein the patterning leaves the first oxide semiconductor layer at least partially intact.

For example, the substrate may comprise a buffer layer, e.g. in the form of a continuous oxygen passing layer, on top. The substrate may further comprise bottom gate layers, e.g. a gate metal and/or a gate dielectric layer which can be arranged below the buffer layer. The first oxide semiconductor layer can be formed on said buffer layer. The second oxide semiconductor layer can be formed directly on the second oxide semiconductor layer, e.g. in a subsequent deposition step.

In an embodiment, the step of patterning the metallic layer comprises forming a trench, wherein the second oxide semiconductor layer is formed on the substrate, and wherein the first oxide semiconductor layer is formed within the trench, in particular on the bottom of the trench.

Thereby, in particular, the second oxide semiconductor layer is formed prior to the first oxide semiconductor layer. For example, the metallic layer is formed on the second oxide semiconductor layer followed by the formation of the trench. The first oxide semiconductor layer can then be directly deposited in the trench.

In an embodiment, after patterning the metallic layer, the gate structure is formed on the first oxide semiconductor layer by depositing a high-k dielectric material and/or a work function metal.

In particular, the high-k dielectric material and/or a work function metal are deposited into the trench formed during patterning. The work function metal can be deposited in the form of a metal layer with a specific work function. Said metal layer can be designed to control the threshold voltage Vₜ of the FET device.

In an embodiment, the method further comprises:
- encapsulating the metallic layer and at least the second oxide semiconductor layer by a silicon nitride, SiN, layer and/or a silicon dioxide, SiO₂, layer, prior to patterning the metallic layer.

The encapsulation can also comprise an aluminum oxide (Al₂O₃) layer, a silicon nitride (SiN) layer, an aluminum titanium nitride (AlTiN) layer, an aluminum silicon nitrice (AlSiN) layer and/or an aluminum nitride (AlN) layer. During patterning, the encapsulation layers can be further patterned, e.g. to form a spacer-like formation on active sidewalls of the structure.

A FET device processed with the method of the first aspect shows clear "fingerprints" of that method. For example, the presence of the second oxide semiconductor layer forming the contact layer to the source and the drain structures in addition to the first oxide semiconductor layer forming the channel.

According to a second aspect, the present disclosure relates to a structure for a FET device, in particular a metal-oxide-semiconductor field-effect transistor (MOSFET) or a thin-film-transistor (TFT), the structure comprising:
- a substrate;
- a first oxide semiconductor layer and a second oxide semiconductor layer arranged above the substrate;
- a source structure and a drain structure arranged on the second oxide semiconductor layer;
- a gate structure arranged on the first oxide semiconductor layer;
- wherein the first oxide semiconductor layer forms a channel between the source structure and the drain structure; and
- wherein the second oxide semiconductor layer forms a contact layer to the source structure and the drain structure.

This achieves the advantage that the contact layer can be controlled independently from the channel layer, e.g in terms of thickness or resistivity. Thus, the contact resistivity between the channel and the source/drain structures can be optimized without negatively affecting the channel itself, and vice versa.

The structure can form a portion or section of the FET device or can form the entire FET device. The FET device can be a planar transistor, in particular a TFT, or another type of transistor, such as a FinFET.

In an embodiment, the first and/or the second oxide semiconductor layer comprises any one of the following materials: indium gallium zinc oxide (IGZO), indium tin oxide (ITO) or indium zinc oxide (IZO).

In an embodiment, the first oxide semiconductor layer comprises a doping, in particular by oxygen vacancies, wherein the doping, in particular a concentration of dopants, of the first oxide semiconductor layer can be modified by means of an oxygen annealing process.

This achieves the electrical properties of the FET, especially its channel layer can be efficiently controlled. In particular, damages or defects in the channel layer that are, for instance, introduced during fabrication of the device and that change the doping of said layer in an unwanted way can be removed, and a desired concentration of oxygen dopants in the layer can be recovered.

Modifying the doping in the first oxide semiconductor layer may refer to a restoring of damages and/or a filling up of oxygen (02) vacancies that occurred during the fabrication of the FET.

In an embodiment, the second oxide semiconductor layer comprises a first contact layer to the source structure and a second contact layer to the drain structure.

In particular, the first contact layer and the second contact layer can be separated by a trench, which was, e.g., formed during a fabrication step of the structure.

In an embodiment, the first oxide semiconductor layer is arranged on the substrate, wherein the second oxide semiconductor layer is arranged on the first oxide semiconductor layer.

In an embodiment, the second oxide semiconductor layer is arranged on the substrate, and the first oxide semiconductor layer is arranged within a trench, in particular on the bottom of the trench, wherein the trench is arranged between the source and the drain structure.

### BRIEF DESCRIPTION OF THE DRAWINGS

Embodiments of the invention will be explained in the followings together with the figures.
- Figs. 1a-j: show steps of a method for processing a FET device according to an embodiment;
- Fig. 2: shows a substrate for an FET device according to an embodiment;
- Figs. 3a-b: show steps of a method for processing a FET device according to an embodiment;
- Fig. 4: shows a structure for a FET device according to an embodiment; and
- Figs. 5a-b: show structures for FET devices according to further embodiments.

### DETAILED DESCRIPTION OF THE PREFERRED EMBODIMENTS

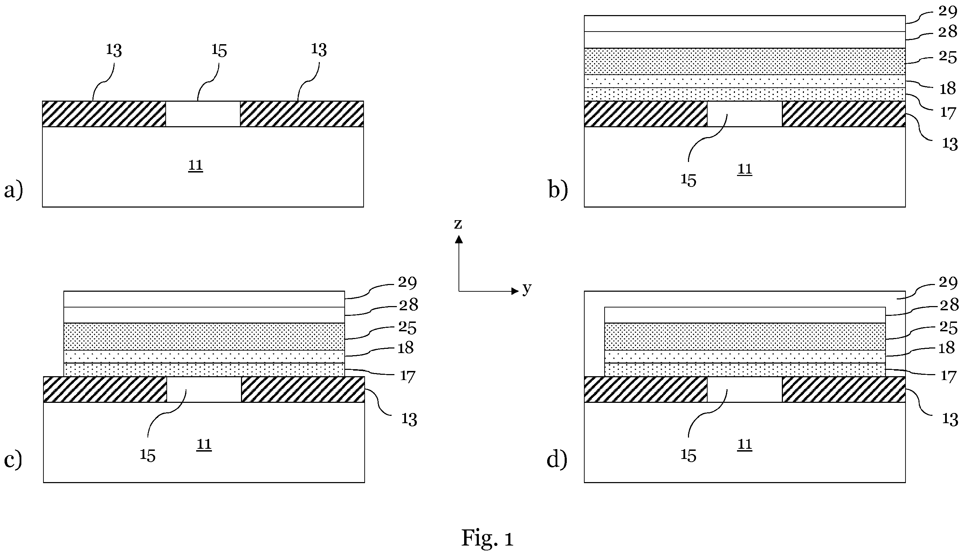

Figs. 1a-j show steps of a method for processing a FET device according to an embodiment.

Thereby, Figs. 1a-j show the processing of a single FET device. Nevertheless, the method may be used to process a plurality of FET devices in parallel, in particular on the same substrate 11.

The method comprises, as shown in Fig. 1a, providing a substrate 11. The substrate 11 can be a glass or a silicon wafer. In particular, the substrate 11 is a wafer, e.g. a 300 mm wafer.

The substrate 11 shown in Figs 1a-j comprises an oxygen passing layer 15 and an oxygen blocking layer 13 on its surface. Thereby, the oxygen blocking layer 13 is arranged next to the oxygen passing layer 15 and delimits the oxygen passing layer 15 on two opposite sides. The oxygen passing layer 15 may facilitate a modification of a doping of an overlying channel layer, as will be explained for Fig. 1b below. The oxygen passing layer 15 can extend along an x-direction, perpendicular to the cross-sectional view in y-z-direction as indicated by the schematic coordinate system in Figs. 1a-j.

The oxygen passing layer 15 may comprises a silicon oxide layer, a silicon oxynitride layer, a porous material layer, and/or an air gap. The oxygen blocking layer 13 may comprise a metallic and/or a dielectric material layer, e.g. tungsten nitride, silicon nitride, aluminum oxide, titanium, titanium nitride, ruthenium, hafnium dioxide, molybdenum, titanium tungsten, silver, gold, or silicon carbonitride. Both these layers 13, 15 can be formed by a suitable deposition technique.

The oxygen passing layer 15 can be defined by a high permeability for oxygen, e.g. a material with a high diffusion coefficient for oxygen, and the oxygen blocking layer 13 can be defined by a low permeability for oxygen. E.g., the oxygen blocking layer 13 forms a diffusion barrier for oxygen.

Alternatively or additionally to the oxygen passing layer 15 and the oxygen blocking layer 13, the substrate may comprise a buffer layer e.g. in the form of a continuous oxygen passing layer, a bottom gate layer, e.g. comprising a gate metal and/or gate dielectric layer, or no surface layer at all on its top side.

As shown in Fig. 1b, the method further comprises forming a first oxide semiconductor layer 17 and a second oxide semiconductor layer 18 above the substrate 11.

Each of the first and the second oxide semiconductor layers 17, 18 can be a metal-oxide semiconductor or a doped metal-semiconductor layer. In particular, the first oxide semiconductor layer 17 and/or the second oxide semiconductor layer 18 can be made of any one of the following materials: indium gallium zinc oxide (IGZO), indium tin oxide (ITO) or indium zinc oxide (IZO).

In particular, the first oxide semiconductor layer 17 and the second oxide semiconductor layer 18 can be made from the same material, e.g. IGZO, each with a different doping, stochiometry and/or crystallinity.

The first and second oxide semiconductor layers 17, 18 can be deposited with a suitable deposition technique, for instance by any combination of atomic layer deposition (ALD) and physical vapor deposition PVD, e.g. ALD/ALD, PVD/PVD, ALD/PVD or PVD/ALD.

Preferably, the first oxide semiconductor layer 17 forms the channel layer of the FET device, and the second oxide semiconductor layer 18 forms a contact layer between the channel and source and drain structures, which are formed in a subsequent step. Forming the channel layer 17 and the contact layer 18 as two separate material layers allows controlling the thickness and electrical properties of these layers 17, 18 independently from each other. For example, the channel layer 17 can be formed from a material with a high electrical resistivity while the contact layer 18 can be formed from a compatible material with a high conductivity.

In particular, by forming the contact layers to the source and drain structures from a separate material layer 18 that is different from the channel layer 17, it might no longer be necessary to modify the source/drain areas of the channel layer 17 to reduce the contact resistivity, e.g. via an additional silicidation step. Furthermore, this integration scheme can further suppress the access resistance area, which can be beneficial for the performance of the FET device. The access resistance, typically, depends on the distance between the source and the gate. To increase the density of FET devices on a substrate, this distance tends to be reduced, e.g. to the spacer thickness for 14 nm FinFets by using advanced patterning methods, such as self-aligned contact (SAC) methods.

Subsequent to the formation of the oxide semiconductor layers 17, 18, a metallic layer 25 can be formed on the second oxide semiconductor layer 18. In addition, a hard mask, e.g. made of a silicon nitride (Si₃N₄) layer 28 and a silicon dioxide (SiO₂) layer 29, can be deposited on top of the metallic layer 25.

Optionally, an additional barrier layer (not shown) can be formed between the second oxide semiconductor layer 18 and the metallic layer 25, e.g. via deposition prior to the forming of the metallic layer 25.

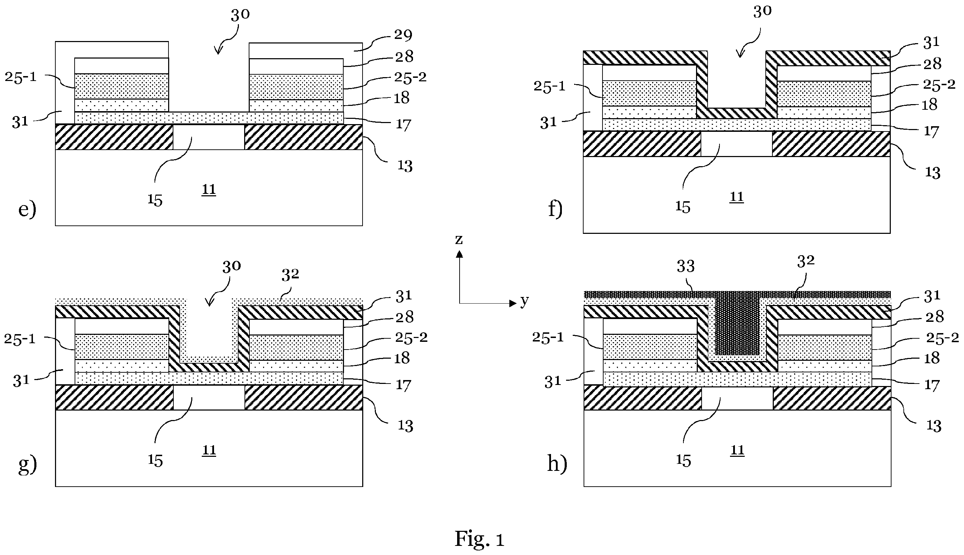

Subsequent to the deposition of the metallic layer 25 or the hard mask 28/29, an oxygen annealing step can be performed. The oxygen annealing step can, also, be carried out at a later stage of the processing, e.g. after stack deposition and first patterning (i.e., after the step shown in Fig. 1e), or at the end of the processing of the FET device.

During the oxygen annealing, oxygen atoms can be inserted into the oxygen passing layer 15, which forms a channel for the oxygen atoms below the first oxide semiconductor layer 17. The oxygen atoms can penetrate the first oxide semiconductor layer 17 in a section above the oxygen passing layer 15 and, thus, change the concentration of dopants, in particular oxygen vacancies, in the oxygen passing layer 15. In this way, damages in the first oxide semiconductor layer 17 caused by previous fabrication steps can be eliminated and an intended doping of the first oxide semiconductor 17 can be restored.

In a further step, shown in Figs. 1c, the layers 17, 18, 25, 28, 29 can be partially removed, e.g. via lithographic patterning. Subsequently, as shown in Fig. id, the layers 17, 18, 25, 28, 29 can be encapsulated by a Si02 sacrificial layer.

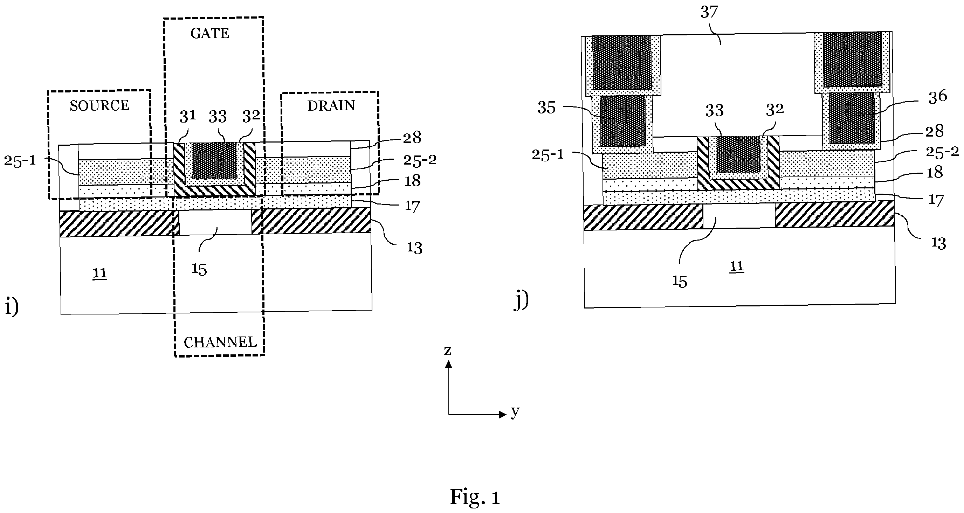

In a further step, shown in Fig. 1e, the metallic layer 25 is patterned to form source and drain structures. As shown in Fig. 1, the patterning can comprise forming a trench 30 in the metallic layer 25 by recessing the metallic layer 25 in a center region. The trench 30 can separate the metallic layer 25 into the source structure 25-1 and the drain structure 25-2. In particular, the source structure 25-1 and the drain structure 25-2 are mostly formed from the metallic layer 25 and are, thus, metallic structures. By forming the source structure 25-1 and the drain structure 25-2 prior to the gate structures might, it might no longer be needed to use an additional contact mask after gate module formation, which can lead to further cost reduction.

The trench 30 can be formed by lithographic patterning of the layers 18, 25, 28, 29, e.g. by means of a suitable wet and/or dry etching technique.

As shown in Fig. 1e, the trench 30 may also pass through the second oxide semiconductor layer 18, and separate said second oxide semiconductor layer 18 into a first contact layer to the source structure 25-1 and a second contact layer to the drain structure 25-2. Thereby, the trench 30 may leave the first oxide semiconductor layer 17 at least partially intact.

In further steps, shown in Figs. 1f-h, a gate structure is formed on the first oxide semiconductor layer 17. The gate structure may be formed depositing any combination of suitable materials into the trench 30.

The gate structure can be formed in the form of a gate stack by filling the trench with a gate dielectric (layer 31), followed by work function controlling metal (layer 32), and a gate contact metal (layer 33). The work function controlling layer 32 can be designed to control the threshold voltage Vₜ of the FET device. For example, the work function controlling layer 32 is made from titanium nitride (TiN) or titanium aluminum.

By an advantageous design of the gate structure, the access to the channel layer 17 for an oxygen annealing and/or for a doping, e.g. by means of plasma or element implantation, might be improved. Additionally, the access can be enhanced by the oxygen passing layer 15.

In a further step, shown in Figs. 1i, a chemical mechanical polishing (CMP) can be performed to remove excess material on the top of the structure. In particular, remains of the layers 31, 32, 33 outside of the trench 30 can, thereby, be removed.

Fig. 1i shows an example of a structure for the FET device, wherein the sections of the structure that will form the source, drain, gate and channel of the FET device are highlighted.

In a final step, shown in Fig. ij, a further SiO₂ layer 37 can be formed on top of the structure. The source structure 25-1 and the drain structure 25-2 can, subsequently, be electrically contacted by etching vias 35, 36 into the further SiO₂ layer 37 and filling said vias 35, 36 with a metallic material to form metallic contacts for contacting the source structure 25-1 and the drain structure 25-2.

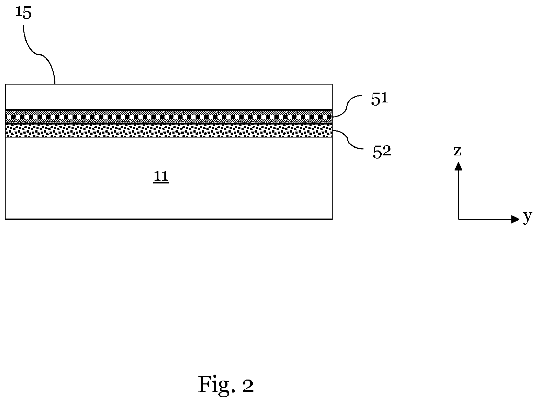

Fig. 2 shows a substrate 11 for an FET device according to an embodiment.

In particular, Fig. 2 shows an alternative substrate 11 that can be used in the process shown in Figs. 1a-j. All steps shown in Figs. 1b-j can also be carried out on a substrate 11 as shown in Fig. 2.

The substrate 11 shown in Fig. 2, comprises a continuous oxygen passing layer 15 on top, instead of an oxygen passing layer 15 that is delimited by an oxygen blocking layer 13 as shown in Fig. 1a. In addition, the substrate 11 shown in Fig. 2 comprises a bottom gate dielectric layer 51 and a bottom gate metal layer 52 arranged below the oxygen passing layer 15. Thus, by using the substrate 11 as shown in Fig. 2, a FET device with a bottom gate can be processed using the steps shown in Figs. 1a-j.

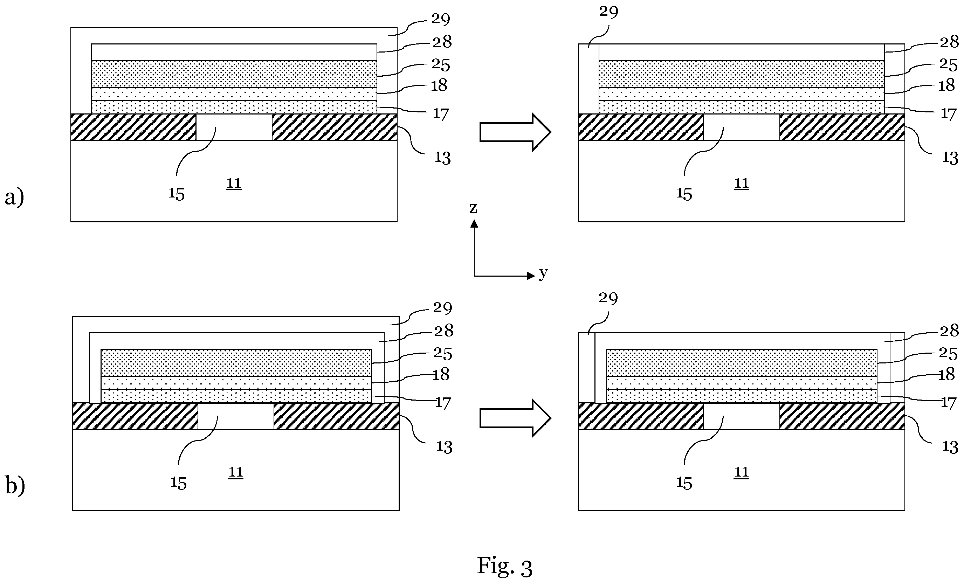

Figs. 3a-b show steps of a method for processing the FET device according to an embodiment. In particular, Figs. 3a-b show possible alternative steps for forming and partially removing the encapsulation prior to generating the trench 30 in Fig. 1e.

Fig. 3a shows a first alternative, where the Si02 encapsulation layer 29 shown in Fig. id is partially removed by a CMP step that is selective to the Si₃N₄ layer 28.

Fig. 3b shows another alternative, where a Si₃N₄ encapsulation layer 28 is formed by a Si₃N₄ liner deposition and subsequent etching. Subsequently the Si02 encapsulation layer 29 is formed by a Si02 gap fill deposition. The Si02 encapsulation 29 is then partially removed by the Si₃N₄ selective CMP step.

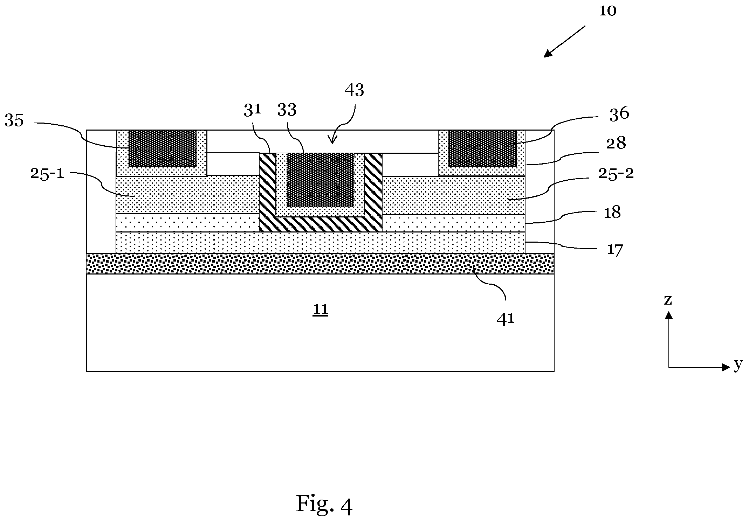

Fig. 4 shows a structure 10 for a FET device according to an embodiment. In particular, the structure 10 shown in Fig. 4 was processed by the method depicted in Figs. 1a-j.

The structure 10 comprises the substrate 11, the first oxide semiconductor layer 17 and the second oxide semiconductor layer 18 arranged above the substrate 11. The structure 11 further comprises the source structure 25-1 and the drain structure 25 -2 arranged on the second oxide semiconductor layer, as well as the gate structure 43 arranged on the first oxide semiconductor layer 17.

Thereby, the first oxide semiconductor layer 17 forms a channel between the source structure 25-1 and the drain structure 25-2, and the second oxide semiconductor layer 18 forms a contact layer to the source structure 25-1 and the drain structure 25-2.

In particular, the second oxide semiconductor layer 18 comprises a first contact layer to the source structure 25-1 and a second contact layer to the drain structure 25-2. A buffer layer can be arranged between the second oxide semiconductor layer 18 and the source structure 25-1 respectively drain structure 25-2.

The structure 10 may further comprise an optional bottom gate dielectric and/or buffer layer 41, which is arranged between the substrate 11 and the channel layer 17. The buffer layer 41 can be a continuous oxygen passing layer. For example, the first semiconductor oxygen layer 17 may be arranged on an oxygen passing layer 15, a gate dielectric layer 51 and a bottom gate metal layer 52, as shown in Fig. 2, or on an oxygen passing layer 15 and an oxygen blocking layer 13, as shown in Figs. 1a.

The gate structure 43 can comprise a gate dielectric layer that is formed above the first oxide semiconductor layer 17. Several top gate dielectric materials, thicknesses and crystallinities can be used. Possible top gate materials are aluminum oxide (Al₂O₃), hafnium dioxide (HfO₂), or wide band gap oxide semiconductors, such as gallium zinc oxide (GZO) or silicon dioxide (SiO₂). The gate structure 43 can further comprise an electric contact.

The first oxide semiconductor layer 17 can be arranged on the substrate 11, in particular on the bottom gate dielectric or buffer layer 41 covering the substrate 11. The second oxide semiconductor layer 18 can be arranged on the first oxide semiconductor layer 17, preferably in contact with the first oxide semiconductor layer 17.

Each of the first and the second oxide semiconductor layers 17, 18 can be a metal-oxide semiconductor or a doped metal-semiconductor layer. In particular, first oxide semiconductor layer 17 and/or the second 18 can be made of any one of the following materials: indium gallium zinc oxide (IGZO), indium tin oxide (ITO) or indium zinc oxide (IZO). In particular, at least the first oxide semiconductor layer 17 comprises a doping, e.g. by oxygen vacancies.

Preferably, the first oxide semiconductor layer 17 has a high electrical resistivity, whereas the second oxide semiconductor layer 18 has a high conductivity.

By performing an oxygen annealing process, a concentration of the dopants in the first oxide semiconductor layer 17 can be changed respectively restored to a desired value. In this way, damages that were generated in the first oxide semiconductor layer 17 during a fabrication of the structure 10 can be repaired.

The structure 10 can form at least a portion of a TFT, MOSFET, FinFET or other type of transistor.

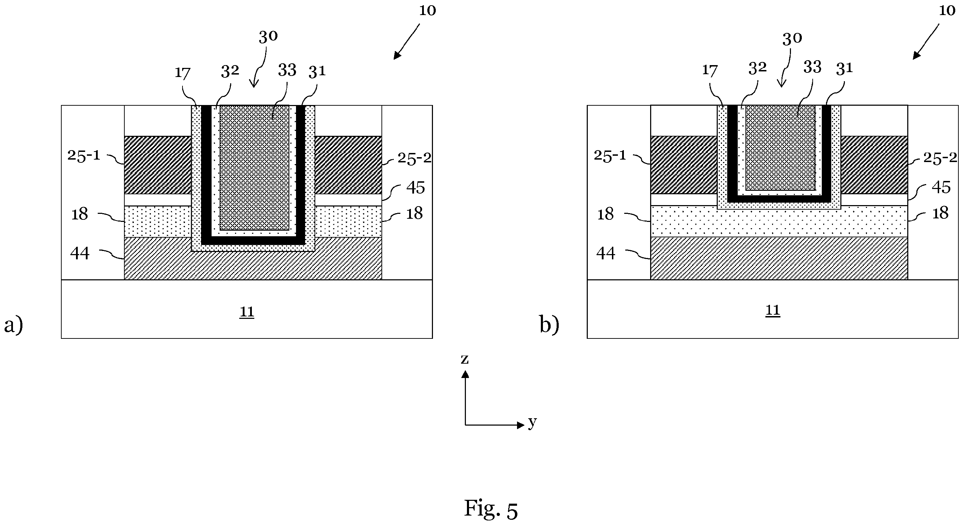

Figs. 5a-b show structures 10 for FET devices according to further embodiments.

In the embodiments shown in Fig. 5a and 5b, the second oxide semiconductor layer 18 is arranged on the substrate 11, in particular on a buffer layer 44 of the substrate, and the first oxide semiconductor layer 17 is arranged within the trench 30 that was formed during patterning of the metallic layer 25. An additional barrier layer 45 can be arranged between the second oxide semiconductor layer 18 and the source and drain structures 25-1, 25-2.

In particular, the structures 10 as shown in Figs. 5a and 5b were processed with an alternative method as compared to the method shown in Figs. 1a-j, wherein the second oxide semiconductor layer 18 is formed prior to the first oxide semiconductor layer 17. For example, the structures 10 shown in Figs. 5a and 5b were processed by depositing the second oxide semiconductor layer 18 on the substrate 11, depositing the metallic layer 25 on the second oxide semiconductor layer, forming the trench 30 in the metallic layer 25 to separate the metallic layer 25 into the source and the drain structures 25-1, 25-2, and, subsequently, depositing the first oxide semiconductor layer 17 within the trench 30, in particular on the bottom of the trench 30. After depositing the first oxide semiconductor layer 17, the gate dielectric 31, the work function controlling layer and/or the gate contact metal 33 can be deposited in the trench 30.

In the structure 10 shown in Fig. 5a, the trench 30 passes through the second oxide semiconductor layer 18, and separates said second oxide semiconductor layer 18 into the first contact layer to the source structure 25-1 and the second contact layer to the drain structure 25-2.

In contrast, in the structure 10 shown in Fig. 5b, the trench 30 does not pass through the second oxide semiconductor layer 18. Thus, this layer 18 is not physically separated in two parts.

## Claims

1. A method for processing a FET device, in particular a metal-oxide-semiconductor field-effect transistor, MOSFET, or a thin-film-transistor, TFT, wherein the method comprises:
- providing a substrate (11);
- forming a first oxide semiconductor layer (17) and a second oxide semiconductor layer (18) above the substrate (11);
- forming a source structure (25-1) and a drain structure (25-2) on the second oxide semiconductor layer (18);
- forming a gate structure (43) on the first oxide semiconductor layer (17);
- wherein the first oxide semiconductor layer (17) forms a channel between the source structure (25-1) and the drain structure (25-2); and
- wherein the second oxide semiconductor layer (18) forms a contact layer to the source structure (25-1) and the drain structure (25-2).

2. The method according to claim 1, wherein the first and/or the second oxide semiconductor layer (17, 18) comprises any one of the following materials: indium gallium zinc oxide, IGZO, indium tin oxide, ITO, or indium zinc oxide, IZO.

3. The method according to claim 1 or 2, wherein the method further comprises the step of:
- performing an oxygen annealing to modify a doping of the first oxide semiconductor layer (17).

4. The method according to any one of the preceding claims, wherein the source and the drain structure are formed by:
- forming a metallic layer (25) on the second oxide semiconductor layer (18), and
- patterning the metallic layer (25) thereby forming the source structure (25-1) and the drain structure (, 25-2).

5. The method according to claim 4, wherein the step of patterning the metallic layer (25) further comprises separating said second oxide semiconductor layer (18) into a first contact layer to the source structure (25-1) and a second contact layer to the drain structure (25-2).

6. The method according to claim 4 or 5, wherein the first oxide semiconductor layer (17) is formed on the substrate (11), wherein the second oxide semiconductor layer (18) is formed on the first oxide semiconductor layer (17), and wherein the patterning leaves the first oxide semiconductor layer (17) at least partially intact.

7. The method according to claim 4 or 5, wherein the step of patterning the metallic layer (25) comprises forming a trench (30), wherein the second oxide semiconductor layer (18) is formed on the substrate (11), and wherein the first oxide semiconductor layer (17) is formed within the trench (30), in particular on the bottom of the trench (30).

8. The method according to any one of claims 4 to 7, wherein, after patterning the metallic layer (25), the gate structure (43) is formed on the first oxide semiconductor layer (17) by depositing a high-k dielectric material and/or a work function metal.

9. The method according to any one of claims 4 to 8, wherein the method further comprises:
- encapsulating the metallic layer (25) and at least the second oxide semiconductor layer (18) by a silicon nitride, SiN, layer and/or a silicon dioxide, SiO₂, layer, prior to patterning the metallic layer (25).

10. A structure (10) for a FET device, in particular a metal-oxide-semiconductor field-effect transistor, MOSFET, or a thin-film-transistor, TFT, the structure comprising:
- a substrate (11);
- a first oxide semiconductor layer (17) and a second oxide semiconductor layer (18) arranged above the substrate (11);
- a source structure (25-1) and a drain structure (25-2) arranged on the second oxide semiconductor layer (18);
- a gate structure (43) arranged on the first oxide semiconductor layer (17);
- wherein the first oxide semiconductor layer (17) forms a channel between the source structure (25-1) and the drain structure (25-2); and
- wherein the second oxide semiconductor layer (18) forms a contact layer to the source structure (25-1) and the drain structure (25-2).

11. The structure (10) according to claim 10, wherein the first and/or the second oxide semiconductor layer (17, 18) comprises any one of the following materials: indium gallium zinc oxide, IGZO, indium tin oxide, ITO, or indium zinc oxide, IZO.

12. The structure according to claim 10 or 11, wherein the first oxide semiconductor layer (17) comprises a doping, in particular by oxygen vacancies, wherein the doping, in particular a concentration of dopants, of the first oxide semiconductor layer (17) can be modified by means of an oxygen annealing process.

13. The structure according to any one of claims 10 to 12, wherein the second oxide semiconductor layer (18) comprises a first contact layer to the source structure (25-1) and a second contact layer to the drain structure (25-2).

14. The structure (10) according to any one of claims 10 to 13, wherein the first oxide semiconductor layer (17) is arranged on the substrate (11), and wherein the second oxide semiconductor layer (18) is arranged on the first oxide semiconductor layer (17).

15. The structure according to any one of claims 10 to 13, wherein the second oxide semiconductor layer (18) is arranged on the substrate (11), and wherein the first oxide semiconductor layer (17) is arranged within a trench (30), in particular on the bottom of the trench (30), wherein the trench (30) is arranged between the source and the drain structure (25-1, 25-2).
